(19) Europäisches Patentamt

European Patent Office

Office européen des brevets

(11) **EP 1 076 415 A1**

(12) **EUROPEAN PATENT APPLICATION**

(43) Date of publication:
**14.02.2001 Bulletin 2001/07**

(51) Int Cl.$^7$: **H03H 17/06**

(21) Application number: **99250269.0**

(22) Date of filing: **11.08.1999**

| | |
|---|---|
| (84) Designated Contracting States:<br>**AT BE CH CY DE DK ES FI FR GB GR IE IT LI LU<br>MC NL PT SE**<br>Designated Extension States:<br>**AL LT LV MK RO SI**<br><br>(71) Applicant: **DEUTSCHE THOMSON-BRANDT<br>GMBH<br>78048 Villingen-Schwenningen (DE)** | (72) Inventor: **Gao, Fei<br>30449 Hannover (DE)**<br><br>(74) Representative:<br>**Hartnack, Wolfgang, Dipl.-Ing. et al<br>Deutsche Thomson-Brandt GmbH<br>European Patent Operations<br>Karl-Wiechert-Allee 74<br>30625 Hannover (DE)** |

(54) **Method and apparatus for sampling frequency conversion**

(57)     There are three different sampling frequencies used in MPEG1 audio, namely 32kHz, 44.1kHz and 48kHz. DVD players are most often sampled at 48kHz, but audio CD players are sampled at 44.1kHz. If such devices are connected to e.g. a digital audio amplifier, and generally for MPEG processing, a corresponding sampling frequency conversion is required. The sampling frequency conversion is carried out using a chain of upsamplers and downsamplers together with proper lowpass filtering, wherein the single up- or downsampling stages do use small conversion ratios.

44.1 kHz                                                   48 kHz

**Fig.6**

Printed by Jouve, 75001 PARIS (FR)

**Description**

The invention relates to a method and to an apparatus for converting samples with an input sampling frequency into samples with an output sampling frequency different from said input sampling frequency.

Background

There are three different sampling frequencies used in MPEG1 audio, namely 32kHz, 44.1kHz and 48kHz. DVD players are most often sampled at 48kHz, but audio CD players are sampled at 44.1kHz. If such devices are connected to e.g. a digital audio amplifier a corresponding sampling frequency conversion is required.
For converting sampling frequencies in oversampled analog-to-digital converters normally a comb-filter and sigma-delta modulation are used.

Invention

An MPEG1 audio encoder must be able to encode PCM samples of an audio source sampled at one of these sampling frequencies into a bitstream sampled by another of these sampling frequencies. For an MPEG audio decoder it is convenient and economic to perform a one-sampling-frequency processing only and to feed the reconstructed PCM samples to a digital-to-analog converter (DAC) allowing three sampling frequencies. In the MPEG2 audio BC standard an audio decoder must support six sampling frequencies. In the MPEG2 or MPEG4 audio AAC standards an audio decoder must support fifteen sampling frequencies.

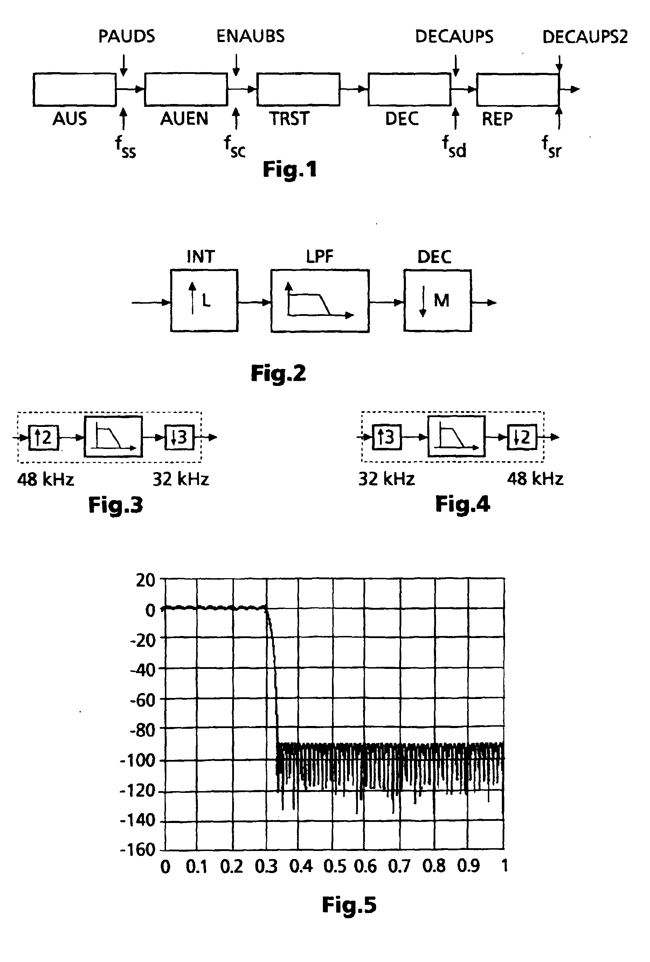

Fig. 1 illustrates a sampling frequency conversion chain in an MPEG audio codec system. An audio source AUS delivers a PCM audio data stream PAUDS with a sampling frequency $f_{ss}$. A following audio encoder AUEN outputs an encoded audio bitstream ENAUBS with a sampling frequency $f_{sc}$. The output of a following transmission path or storage medium/device TRST is received by a decoder DEC which delivers a decoded audio PCM stream DECAUPS with a sampling frequency $f_{sd}$. A following reproduction stage REP outputs a decoded audio PCM stream DECAUPS2 with a sampling frequency $f_{sr}$.
In MPEGI the four sampling frequencies might have the following values:

$f_{ss}$ = 32kHz, 44.1kHz, or 48kHz
$f_{sc}$ = 32kHz, 44.1kHz, or 48kHz
$f_{sd}$ = fsc normally
$f_{sr}$ = 32kHZ, 44.1kHz, or 48kHz

A sampling frequency conversion is required if $f_{ss} \neq f_{sc}$ or $f_{sd} \neq f_{sr}$. The total amount of possible sample frequency combinations is nine.
In MPEG2 audio BC codecs there are 36 possible combinations, and in MPEG2 audio AAC codecs there are 225 possible combinations. The invention allows to carry out all of them with minimum hardware complexity.
It is one object of the invention to disclose a method for sampling frequency conversion with multi-ratio capability and simple hardware. This object is achieved by the method disclosed in claim 1.
It is a further object of the invention to disclose an apparatus which utilises the inventive method. This object is achieved by the apparatus disclosed in claim 7.
According to the invention, the sampling frequency conversion is carried out using a chain of upsamplers and downsamplers together with proper lowpass filtering, wherein the single up- or downsampling stages do use small conversion ratios.
Advantageously, the filtering is carried out using a set of subfilters such that subfilters and conversion stages correspond with respect to the conversion ratio to one of the functional blocks out of those depicted in Fig. 1, i.e. are distributed over several audio or video processing stages or devices.
Thereby the necessary combinations and parameters are derived from the following rules:

a) estimate the desired overall sampling frequency conversion ratio between the original and output sampling frequencies in order to find a common conversion factor, using preferably prime numbers and/or Z transform;
b) decompose this overall ratio into a couple of denominator L and numerator M pairs in product form, using for these pairs numbers as small as possible, preferably prime numbers or powers of two or combinations of a prime number and a power of two, wherein a 'small number' means a number not greater than sixteen. The numbers may include a single '1' in one of the denominators or numerators of the chain;
c) combine all the pair products in such a way that a minimum number of L/M conversion stages results therefrom;
d) select the cut-off frequency of the low pass filters concerned such that $f_{cutoff} = 1/\max\{M,L\}$, whereby the audio samples are upsampled by factor L and downsampled by factor M consecutively using an FIR or an IIR filter. For the last conversion ratio stage this is not in any case necessary;

e) estimate the subfilters and the partition of subfilter coefficients if a polyphase filter structure is employed. Preferably, select the partition of subfilters such that each stage corresponds with respect to the conversion ratio to one of the functional blocks out of those depicted in Fig. 2.

In principle, the inventive method is suited for converting samples having an input sampling frequency into samples having an output sampling frequency different from said input sampling frequency, including the following steps:

- determining the overall sampling frequency conversion ratio;
- decomposing said overall conversion ratio into several denominator and numerator pairs in product form, wherein said denominator represents an upsampling ratio and said numerator represents a downsampling ratio;
- processing input samples having said input sampling frequency in a chain of denominator/numerator pair stages,

wherein the last of said stages provides output samples having said output sampling frequency and wherein in each of said stages a lowpass filter is arranged between upsampling means representing said denominator and downsampling means representing said nominator.

Advantageous additional embodiments of the inventive method are disclosed in the respective dependent claims.

In principle the inventive apparatus is suited for the conversion of samples having an input sampling frequency into samples having an output sampling frequency different from said input sampling frequency, and includes a chain of denominator/numerator pair stages processing input samples having said input sampling frequency, wherein the overall sampling frequency conversion ratio is decomposed into several of said denominator and numerator pairs in product form and wherein said denominator represents an upsampling ratio and said numerator represents a downsampling ratio, and wherein the last of said stages provides output samples having said output sampling frequency and in each of said stages a lowpass filter is arranged between upsampling means representing said denominator and downsampling means representing said nominator.

Advantageous additional embodiments of the inventive apparatus are disclosed in the respective dependent claims.

Drawings

Embodiments of the invention are described with reference to the accompanying drawings, which show in:

Fig. 1     sampling frequency conversion chain in an audio codec system;
Fig. 2     fractional sampling frequency conversion;
Fig. 3     downsampling from 48kHz to 32kHz;
Fig. 4     upsampling from 32kHz to 48kHz;
Fig. 5     filter with 1/3 cut-off frequency;
Fig. 6     multistage sampling frequency converter 44.1kHz to 48kHz;
Fig. 7     multistage sampling frequency converter 44.1kHz to 48kHz;
Fig. 8     multistage sampling frequency converter 64kHz to 11.025kHz
Fig. 9     multistage sampling frequency converter 7kHz to 44.1kHz.

Exemplary embodiments

For carrying out a rational conversion, the conversion ratio is expressed as a product of pairs with the fraction L/M, which means interpolation by a factor L followed by a decimation or subsampling with factor M as depicted in Fig. 2. In order to avoid alias components being introduced by the decimation, an anti-imaging filter is used, i.e. between the interpolator INT and the decimator DEC an anti-aliasing filter LPF is arranged. Practically, a low pass filter (kernel filter) only is required.

Advantageously, a most efficient form of rational ratio conversion can be accomplished using a z-transform representation of the operations involved. Specifically, the z-transform representation of a decimator is:

$$H(z) = \sum_{n=0}^{M-1} z^{-n} H_n(z^M)$$

This formula describes the decimator as a sum of decimation filters $H_n$, multiplied by a phase-dependent delay element $z^{-n}$. A corresponding z-transform representation of an interpolator is:

$$G(z) = \sum_{n=0}^{L-1} z^{-n} G_n(z^L)$$

Then a fact derived from number theory is employed, saying that if two numbers are relatively prime, then there are also associated integers $l_0$ and $m_0$ for which the following applies:

$$l_0 L - m_0 M = -1$$

This allows to replace the delay represented in z domain with:

$$z^{-n} = z^{n}(l_0 L - m_0 M)$$

This formula means that the positions of the upsampling and downsampling stages can be swapped. Advantageously these rules applicable to positioning up- and downsamplers are used for swapping their positions in order to reduce the computational complexity.
In case of multiple input devices operating with different output sampling frequencies (e.g. 32kHz, 24kHz, 16kHz) it is for instance possible to convert these output sampling frequencies in a first step or device into a common intermediate sampling frequency (e.g. 48kHz) using one or two (simple) L/M sampling frequency conversion stages per path, and to convert in a second step or device the common intermediate sampling frequency to the final output sampling frequency (e.g. 44.1kHz) using a (more complex) multistage L/M conversion with higher values of L or M included than in the first step.

A partition of polyphase filter coefficients is carried out in case of immediate downsampling (see Fig. 1, i.e. one L/M pair per device in Fig. 1) by using the modulo operation $L_m \bmod M$, where m is the running index of the input samples.

Advantageously, from that filter two or three polyphase filters (subfilters) for up- or downconversion can be derived, see Example 3 below and Fig. 3, 4 and 5. The subfilters are selected periodically , according to the running position of the input sample, and do have fewer coefficients and avoid multiplication of input samples with zero, cf. EP-A-0327982 of the applicant. These features allow to have filter hardware or software operating with reduced clock frequency or speed.

To explain the operation of the invention four examples are given. The first three examples are taken from the table below. The fourth example demonstrates a possible application for other sampling frequency conversions not given in the table.

*Example 1: 48kHz to 32kHz and vice versa*

    a) estimate the ratio of sampling frequencies, in this case it is 2/3 for 48kHz to 32kHz and 3/2 vice versa, or take the ratio factors from the table;
    b) decompose the denominator and numerator. In this example '2' and '3' is kept;
    c) estimate the number of stages. In this example it is '1';
    d) design a low pass filter. In this example the cut-off frequency of the low pass filter is $1/\max\{2,3\} = 1/3$, normalised for the sampling frequency 48kHz. For the downsampling filter, two subfilters are derived from the low pass filter, and three subfilters are derived for upsampling respectively;
    e) use these subfilters to build a polyphase filter and estimate the down- and upsampling positions to achieve efficiency concerning computational complexity. Particularly, using the $3_m \bmod 2$ partition rule for the downsampling:
        for m = 0: result is '0' $\rightarrow$ computing subfilter H0
        for m = 1: result is '0' $\rightarrow$ computing subfilter H1

As a result, for 48kHz to 32kHz conversion a single stage conversion as shown in Fig. 3 is appropriate.

In both, upsampling from 32kHz to 48kHz, and downsampling from 48kHz to 32kHz, it must be ensured that no spectral components fall into the frequency range from 16kHz (above audible or useful frequency range) to 48kHz/2 = 24kHz, referred to as imaging and aliasing respectively. Therefore a filter is designed with a pass band up to 15kHz and a stop band beginning at 16kHz as a prototype low pass filter.

Example subfilter coefficients are:

|      | Subfilter H0 | Subfilter H1 | Subfilter H2 |
|------|------|------|------|
| 0)  | -0.000046337552 | -0.000696307970 | -0.002120607100 |
| 1)  | -0.002402211400 | -0.000242807390 | 0.001298068900 |
| 2)  | -0.000075056485 | -0.000903764800 | 0.000491671900 |
| 3)  | 0.000471488300 | -0.000741375270 | 0.000086536777 |
| 4)  | 0.000651861600 | -0.000596899540 | -0.000188577430 |
| 5)  | 0.000782019450 | -0.000452429130 | -0.000464428310 |
| 6)  | 0.000888169550 | -0.000249289470 | -0.000768400250 |
| 7)  | 0.000936915540 | 0.000045027695 | -0.001083226900 |
| 8)  | 0.000887381770 | 0.000438259750 | -0.001371319700 |
| 9)  | 0.000704386030 | 0.000918321940 | -0.001586381400 |
| 10) | 0.000359372400 | 0.001455633900 | -0.001671773000 |
| 11) | -0.000160713620 | 0.001999606700 | -0.001570816200 |
| 12) | -0.000845496570 | 0.002484197700 | -0.001240198000 |
| 13) | -0.001666096800 | 0.002836383400 | -0.000645592230 |
| 14) | -0.002572463100 | 0.002973470900 | 0.000230182150 |
| 15) | -0.003485594700 | 0.002812420900 | 0.001370317900 |
| 16) | -0.004309711800 | 0.002286341500 | 0.002737528300 |
| 17) | -0.004935067700 | 0.001335646200 | 0.004261397200 |
| 18) | -0.005234797300 | -0.000072202790 | 0.005835449000 |
| 19) | -0.005084274000 | -0.001939209000 | 0.007332532200 |
| 20) | -0.004356416700 | -0.004242511500 | 0.008586986300 |
| 21) | -0.002932509500 | -0.006916299400 | 0.009419139400 |
| 22) | -0.000699659210 | -0.009875585700 | 0.009608264800 |
| 23) | 0.002455615000 | -0.012993174000 | 0.008910194700 |
| 24) | 0.006669929600 | -0.016134696000 | 0.006994928300 |
| 25) | 0.012152636000 | -0.019146593000 | 0.003383801100 |
| 26) | 0.019332926000 | -0.021869196000 | -0.002815283100 |
| 27) | 0.029213852000 | -0.024163738000 | -0.013739541000 |
| 28) | 0.044714794000 | -0.025903074000 | -0.036596633000 |
| 29) | 0.077944155000 | -0.026987655000 | -0.122052580000 |
| 30) | 0.288227500000 | 0.639310560000 | 0.288227500000 |
| 31) | -0.122052580000 | -0.026987655000 | 0.077944155000 |
| 32) | -0.036596633000 | -0.025903074000 | 0.044714794000 |
| 33) | -0.013739541000 | -0.024163738000 | 0.029213852000 |
| 34) | -0.002815283100 | -0.021869196000 | 0.019332926000 |
| 35) | 0.003383801100 | -0.019146593000 | 0.012152636000 |
| 36) | 0.006994928300 | -0.016134696000 | 0.006669929600 |
| 37) | 0.008910194700 | -0.012993174000 | 0.002455615000 |
| 38) | 0.009608264800 | -0.009875585700 | -0.000699659210 |
| 39) | 0.009419139400 | -0.006916299400 | -0.002932509500 |
| 40) | 0.008586986300 | -0.004242511500 | -0.004356416700 |
| 41) | 0.007332532200 | -0.001939209000 | -0.005084274000 |
| 42) | 0.005835449000 | -0.000072202790 | -0.005234797300 |
| 43) | 0.004261397200 | 0.001335646200 | -0.004935067700 |

(continued)

|  | Subfilter H0 | Subfilter H1 | Subfilter H2 |
|---|---|---|---|
| 44) | 0.002737528300 | 0.002286341500 | -0.004309711800 |
| 45) | 0.001370317900 | 0.002812420900 | -0.003485594700 |
| 46) | 0.000230182150 | 0.002973470900 | -0.002572463100 |
| 47) | -0.000645592230 | 0.002836383400 | -0.001666096800 |
| 48) | -0.001240198000 | 0.002484197700 | -0.000845496570 |
| 49) | -0.001570816200 | 0.001999606700 | -0.000160713620 |
| 50) | -0.001671773000 | 0.001455633900 | 0.000359372400 |
| 51) | -0.001586381400 | 0.000918321940 | 0.000704386030 |
| 52) | -0.001371319700 | 0.000438259750 | 0.000887381770 |
| 53) | -0.001083226900 | 0.000045027695 | 0.000936915540 |
| 54) | -0.000768400250 | -0.000249289470 | 0.000888169550 |
| 55) | -0.000464428310 | -0.000452429130 | 0.000782019450 |
| 56) | -0.000188577430 | -0.000596899540 | 0.000651861600 |
| 57) | 0.000086536777 | -0.000741375270 | 0.000471488300 |
| 58) | 0.000491671900 | -0.000903764800 | -0.000075056485 |
| 59) | 0.001298068900 | -0.000242807390 | -0.002402211400 |
| 60) | -0.002120607100 | -0.000696307970 | -0.000046337552 |

*Example 2: 44.1kHz to 48kHz and vice versa*

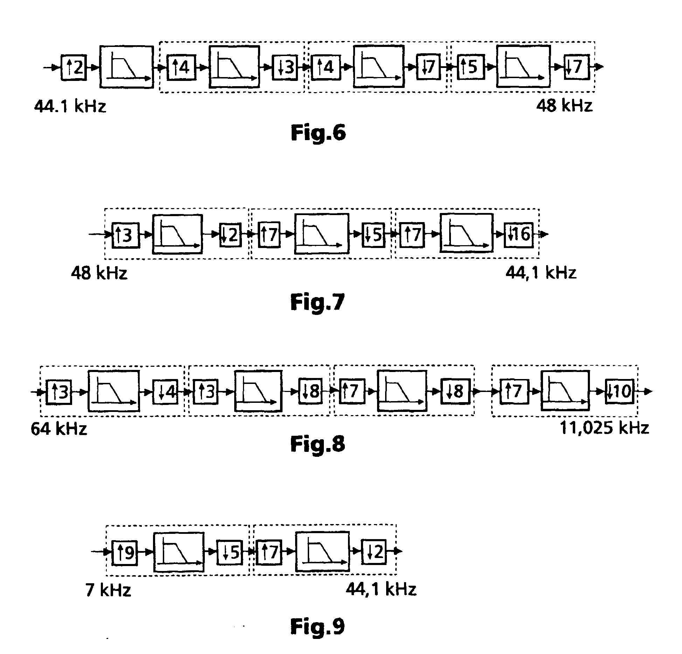

a) take the conversion ratio from the table: 160/147;
b) decompose to 160/147 = (2/1)*(4/3)*(4/7)*(5/7). This is depicted in Fig. 6 with the following conversion stages:

1. stage upsampling by 2 and downsampling by 1
2. stage upsampling by 4 and downsampling by 3
3. stage upsampling by 4 and downsampling by 7
4. stage upsampling by 5 and downsampling by 7;

c) estimate the number of stages. In this example it is '4';
d) the normalised cut-off frequency of the low pass filter is 1/max{2,1} = 1/2, 1/max{4,3} = 1/4, 1/max{4,7} = 1/7, 1/max{5,7} = 1/7, respectively.

Step e) is carried out correspondingly.

a) take the conversion ratio from the table: 147/160;
b) decompose to 147/160 = (3/2)*(7/5)*(7/16). This is depicted in Fig. 7 with the following conversion stages:

1. stage upsampling by 3 and downsampling by 2
2. stage upsampling by 7 and downsampling by 5
3. stage upsampling by 7 and downsampling by 16.

Steps c) to e) are carried out correspondingly.

*Example 3: 64kHz to 11.025kHz and vice versa*

a) take the conversion ratio from the table: 441/2560;
b) decompose to 441/2560 = (3/4)*(3/8)*(7/8)∗(7/10). This is depicted in Fig. 8 with the following conversion stages:

1. stage upsampling by 3 and downsampling by 4
2. stage upsampling by 3 and downsampling by 8

3.stage upsampling by 7 and downsampling by 8
4.stage upsampling by 7 and downsampling by 10

Other combinations are also possible, for example 441/2560 = (3/4)* (3/4)* (7/8)* (7/20).

Steps c) to e) are carried out correspondingly.

*Example 4; 7kHz to 44.1kHz*

For conversion of PCM data sampled at 7kHz to 44.1kHz sampled PCM data the ratio is examined as 63/10 = (9/5)*(7/2). Applying the number theory, two stages of sampling frequency conversion are resulting by applying the two lowpass filters given in Fig. 9.
Steps c) to e) are carried out correspondingly.

A table of converting ratios is given below for all sampling frequencies used in MPEG audio encoders and decoders. A sampling frequency converter can be constructed using this table and the inventive procedure. "UXXX" means upsampling, "DXXX" means downsampling, "U1" or "D1" means that no upsampling or downsampling is necessary. All combinations for sampling frequency conversions required in MPEG1/2 audio and AAC are given.

| to:<br>from: | 96000 | 88200 | 64000 | 48000 | 44100 | 32000 | 24000 | 22050 |
|---|---|---|---|---|---|---|---|---|
| 96000 | | U141<br>D160 | U2<br>D3 | U1<br>D2 | U147<br>D320 | U1<br>D3 | U1<br>D4 | U147<br>D640 |
| 88200 | U160<br>D147 | | U320<br>D441 | U80<br>D147 | U1<br>D2 | U160<br>D441 | U40<br>D147 | U1<br>D4 |
| 64000 | U3<br>D2 | U441<br>D320 | | U3<br>D4 | U441<br>D640 | U1<br>D2 | U3<br>D8 | U441<br>D1280 |
| 48000 | U2<br>D1 | U147<br>D80 | U4<br>D3 | | U147<br>D160 | U2<br>D3 | U1<br>D2 | U147<br>D320 |
| 44100 | U320<br>D147 | U2<br>D1 | U160<br>D147 | U160<br>D147 | | U320<br>D441 | U80<br>D147 | U1<br>D2 |
| 32000 | U3<br>D1 | U441<br>D160 | U2<br>D1 | U3<br>D2 | U441<br>D320 | | U3<br>D4 | U441<br>D640 |
| 24000 | U4<br>D1 | U147<br>D40 | U8<br>D3 | U2<br>D1 | U147<br>D80 | U4<br>D3 | | U147<br>D160 |
| 22050 | U640<br>D147 | U4<br>D1 | U1280<br>D441 | U320<br>D147 | U2<br>D1 | U640<br>D441 | U160<br>D147 | |

| 20000 | U24 D5 | U441 D200 | U16 D5 | U12 D5 | U441 D200 | U8 D5 | U6 D5 | U441 D400 |
|---|---|---|---|---|---|---|---|---|
| 18000 | U12 D3 | U147 D30 | U32 D9 | U8 D3 | U49 D20 | U16 D9 | U4 D3 | U49 D40 |
| 16000 | U6 D1 | U441 D80 | U4 D1 | U3 D1 | U441 D160 | U2 D1 | U3 D2 | U147 D120 |
| 12000 | U8 D1 | U147 D20 | U16 D3 | U4 D1 | U147 D40 | U8 D3 | U2 D1 | U441 D320 |
| 11025 | U1280 D147 | U8 D1 | U2560 D441 | U640 D147 | U4 D1 | U1280 D441 | U320 D147 | U147 D100 |
| 8000 | U12 D1 | U441 D40 | U8 D1 | U6 D1 | U441 D80 | U4 D1 | U3 D1 | U2 D1 |
| 6000 | U16 D1 | U147 D10 | U32 D3 | U8 D1 | U147 D20 | U16 D3 | U4 D1 | U147 D40 |

| to:<br>from: | 20000 | 18000 | 16000 | 12000 | 11025 | 8000 | 6000 |
|---|---|---|---|---|---|---|---|
| 96000 | U5 D24 | U3 D6 | U1 D6 | U1 D8 | U147 D1280 | U1 D12 | U1 D16 |
| 88200 | U5 D22 | U9 D44 | U2 D11 | U3 D22 | U1 D8 | U1 D11 | U20 D147 |
| 64000 | U5 D16 | U9 D32 | U1 D4 | U3 D16 | U441 D2560 | U1 D8 | U3 D32 |
| 48000 | U5 D12 | U3 D8 | U1 D3 | U1 D4 | U147 D640 | U1 D6 | U1 D8 |
| 44100 | U200 D441 | U20 D49 | U160 D441 | U40 D147 | U1 D4 | U80 D441 | U20 D147 |
| 32000 | U5 D8 | U9 D16 | U1 D2 | U3 D8 | U441 D1280 | U1 D4 | U3 D32 |
| 24000 | U5 D6 | U3 D4 | U2 D3 | U1 D2 | U147 D320 | U1 D3 | U1 D8 |
| 22050 | U400 D441 | U40 D49 | U320 D441 | U100 D441 | U1 D2 | U160 D441 | U10 D49 |
| 20000 |  | U9 D10 | U4 D5 | U3 D5 | U441 D800 | U2 D5 | U1 D4 |
| 18000 | U10 D9 |  | U8 D9 | U2 D3 | U49 D80 | U4 D9 | U40 D147 |
| 16000 | U5 D4 | U9 D8 |  | U3 D4 | U441 D640 | U1 D2 | U3 D10 |
| 12000 | U5 D3 | U3 D2 | U4 D3 |  | U147 D160 | U2 D3 | U1 D3 |
| 11025 | U800 D441 | U80 D49 | U640 D441 | U160 D147 |  | U320 D441 | U80 D147 |
| 8000 | U5 D2 | U9 D4 | U2 D1 | U3 D2 | U441 D320 |  | U3 D4 |
| 6000 | U10 D3 | U3 D1 | U8 D3 | U2 D1 | U147 D80 | U4 D3 |  |

Advantageously, if an FIR filter is employed, most of the interpolators and decimators can be realised using the same low pass filter design so that this filter needs to be designed only once.

Advantageously, the processing delay introduced by the inventive multi-stage sampling frequency conversion is still negligible when compared with the encoding or decoding delay introduced by the audio encoder or decoder, respectively. Therefore an automatic and efficient multi-stage PCM sample synchronisation can be carried out by the sampling frequency converter.

The invention can easily be adapted to any desired fractional sampling frequency conversion. It can be used generally in digital audio and other digital systems, e.g. in audio studios, for 32kHz and 48kHz conversion, for home sound track mixing, and for non-MPEG devices and also in video signal coding/decoding and processing sampling frequency converters.

**Claims**

1. Method for converting samples having an input sampling frequency ($f_{ss}$) into samples having an output sampling frequency ($f_{sc}$; $f_{sd}$; $f_{sr}$) different from said input sampling frequency, including the following steps:

   - determining the overall sampling frequency conversion ratio;
   - decomposing said overall conversion ratio into several denominator (L) and numerator (M) pairs in product form, wherein said denominator represents an upsampling ratio and said numerator represents a downsampling ratio;
   - processing input samples having said input sampling frequency in a chain of denominator/numerator pair stages, wherein the last of said stages provides output samples having said output sampling frequency and wherein in each of said stages a lowpass filter (LPF) is arranged between upsampling means (INT) representing said denominator (L) and downsampling means (DEC) representing said nominator (M).

2. Method according to claim 1, wherein for the numbers in said pairs small numbers including prime numbers or powers of two or combinations of a prime number and a power of two are used.

3. Method according to claim 1 or 2, wherein a 'small number' means a number not greater than sixteen.

4. Method according to any of claims 1 to 3, wherein the cut-off frequency of said low pass filter (LPF) is $f_{cut\text{-}off} = 1/\max\{M,L\}$, wherein M is the upsampling ratio in said upsampling means (INT) and L is the downsampling ratio in said downsampling means (DEC).

5. Method according to any of claims 1 to 4, wherein said filtering is carried out using a set of subfilters such that subfilters and/or said pairs correspond with respect to the conversion ratio to one stage or device in a chain of several audio or video processing stages or devices (AUS, AUEN, TRST, DEC, REP) having different functions.

6. Method according to any of claims 1 to 5, wherein said overall conversion ratio is one of the frequency conversion rates defined in connection with MPEGl audio or MPEG2 audio or MPEG2 BC or MPEG2 AAC or MPEG4 AAC.

7. Apparatus for the conversion of samples having an input sampling frequency ($f_{ss}$) into samples having an output sampling frequency ($f_{sc}$; $f_{sd}$; $f_{sr}$) different from said input sampling frequency, including a chain of denominator/numerator pair stages processing input samples having said input sampling frequency, wherein the overall sampling frequency conversion ratio is decomposed into several of said denominator (L) and numerator (M) pairs in product form and wherein said denominator represents an upsampling ratio and said numerator represents a downsampling ratio, and wherein the last of said stages provides output samples having said output sampling frequency and in each of said stages a lowpass filter (LPF) is arranged between upsampling means (INT) representing said denominator (L) and downsampling means (DEC) representing said nominator (M).

8. Apparatus according to claim 7, wherein the numbers in said pairs are small numbers including prime numbers or powers of two or combinations of a prime number and a power of two.

9. Apparatus according to claim 7 or 8, wherein the cut-off frequency of said low pass filter (LPF) is $f_{cutoff} = 1/\max\{M,L\}$, wherein M is the upsampling ratio in said upsampling means (INT) and L is the downsampling ratio in said downsampling means (DEC).

PAUDS ENAUBS DECAUPS DECAUPS2

AUS AUEN TRST DEC REP

$f_{ss}$ $f_{sc}$ $f_{sd}$ $f_{sr}$

**Fig.1**

INT LPF DEC

$\uparrow L$ $\downarrow M$

**Fig.2**

$\uparrow 2$ $\downarrow 3$

48 kHz 32 kHz

**Fig.3**

$\uparrow 3$ $\downarrow 2$

32 kHz 48 kHz

**Fig.4**

**Fig.5**

**Fig.6**

44.1 kHz → ↑2 → [filter] → ↑4 → [filter] → ↓3 → ↑4 → [filter] → ↓7 → ↑5 → [filter] → ↓7 → 48 kHz

**Fig.7**

48 kHz → ↑3 → [filter] → ↓2 → ↑7 → [filter] → ↓5 → ↑7 → [filter] → ↓16 → 44,1 kHz

**Fig.8**

64 kHz → ↑3 → [filter] → ↓4 → ↑3 → [filter] → ↓8 → ↑7 → [filter] → ↓8 → ↑7 → [filter] → ↓10 → 11,025 kHz

**Fig.9**

7 kHz → ↑9 → [filter] → ↓5 → ↑7 → [filter] → ↓2 → 44,1 kHz

<table>
<tr><td>European Patent Office</td><td>**EUROPEAN SEARCH REPORT**</td><td>Application Number<br>EP 99 25 0269</td></tr>
</table>

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | MEYER C: "DIGITAL AUDIO SYNCHRONIZATION IN A MIXED-MEDIA PLANT"<br>SMPTE JOURNAL,US,SMPTE INC. SCARSDALE, N.Y,<br>vol. 102, no. 2, page 132-135 XP000349966<br>ISSN: 0036-1682<br>* abstract *<br>* page 134, left-hand column, line 41 - right-hand column, line 19 *<br>* figures 4,5 * | 1-9 | H03H17/06 |
| X | US 5 717 617 A (CHESTER DAVID BRUCE) 10 February 1998 (1998-02-10)<br>* column 1, line 55 - column 2, line 39 *<br>* column 2, line 66 - column 3, line 27 * | 1,4,5,7,9 | |
| A | * figures 2C,9 * | 2,3,6,8 | |
| X | CHESTER D B: "A GENERALIZED RATE CHANGE FILTER ARCHITECTURE"<br>PROCEEDINGS OF THE INTERNATIONAL CONFERENCE ON ACOUSTICS, SPEECH, AND SIGNAL PROCESSING (ICASSP),US,NEW YORK, IEEE,<br>vol. -, page III-181-III-184 XP000482107<br>ISBN: 0-7803-0946-4 | 1,4,5,7,9 | |
| A | * paragraphs [01.0],[04.0] *<br>* figure 4 * | 2,3,6,8 | TECHNICAL FIELDS SEARCHED (Int.Cl.7)<br>H03H |
| A | US 4 020 332 A (CROCHIERE RONALD ELDON ET AL) 26 April 1977 (1977-04-26)<br>* column 7, line 44 - column 8, line 34 *<br>* figure 4 * | 1-9 | |
| A | EP 0 905 889 A (ROCKWELL INTERNATIONAL CORP) 31 March 1999 (1999-03-31)<br>* abstract * | 1-9 | |

-/--

The present search report has been drawn up for all claims

| Place of search | Date of completion of the search | Examiner |
|---|---|---|
| THE HAGUE | 12 January 2000 | Berbain, F |

EPO FORM 1503 03.82 (P04C01)

European Patent Office

## EUROPEAN SEARCH REPORT

Application Number

EP 99 25 0269

| | DOCUMENTS CONSIDERED TO BE RELEVANT | | |
|---|---|---|---|
| Category | Citation of document with indication, where appropriate, of relevant passages | Relevant to claim | CLASSIFICATION OF THE APPLICATION (Int.Cl.7) |
| A | CROCHIERE R E ET AL: "INTERPOLATION AND DECIMATION OF DIGITAL SIGNALS - A TUTORIAL REVIEW" PROCEEDINGS OF THE IEEE,US,IEEE. NEW YORK, vol. 69, no. 3, page 300-331 XP000615159 ISSN: 0018-9219 * paragraph [000V] * ----- | 1-9 | |
| | | | TECHNICAL FIELDS SEARCHED (Int.Cl.7) |

The present search report has been drawn up for all claims

| Place of search | Date of completion of the search | Examiner |
|---|---|---|
| THE HAGUE | 12 January 2000 | Berbain, F |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

**ANNEX TO THE EUROPEAN SEARCH REPORT
ON EUROPEAN PATENT APPLICATION NO.**                EP 99 25 0269

This annex lists the patent family members relating to the patent documents cited in the above-mentioned European search report.
The members are as contained in the European Patent Office EDP file on
The European Patent Office is in no way liable for these particulars which are merely given for the purpose of information.

12-01-2000

| Patent document cited in search report | | Publication date | Patent family member(s) | | Publication date |
|---|---|---|---|---|---|
| US 5717617 | A | 10-02-1998 | NONE | | |
| US 4020332 | A | 26-04-1977 | AU | 1797776 A | 06-04-1978 |
| | | | BE | 846447 A | 17-01-1977 |
| | | | DE | 2642139 A | 07-04-1977 |
| | | | ES | 451825 A | 16-12-1977 |
| | | | FR | 2326079 A | 22-04-1977 |
| | | | JP | 52040012 A | 28-03-1977 |
| | | | NL | 7610530 A | 28-03-1977 |
| | | | SE | 7610420 A | 25-03-1977 |
| EP 0905889 | A | 31-03-1999 | NONE | | |

EPO FORM P0459

For more details about this annex : see Official Journal of the European Patent Office, No. 12/82